## Europäisches Patentamt
## European Patent Office
## Office européen des brevets

(19)

(11) Numéro de publication: **0 015 785**
**B1**

(12)

# FASCICULE DE BREVET EUROPEEN

(45) Date de publication du fascicule du brevet: **10.02.82**

(21) Numéro de dépôt: **80400025.5**

(22) Date de dépôt: **09.01.80**

(51) Int. Cl.³: **C 08 J 7/04, C 08 J 5/00, B 29 C 5/00, B 32 B 27/42**

(54) Matériaux stratifiés à base de résine phénolique et procédé pour leur préparation.

(30) Priorité: **25.01.79 FR 7901888**

(43) Date de publication de la demande:
**17.09.80 Bulletin 80/19**

(45) Mention de la délivrance du brevet:
**10.02.82 Bulletin 82/6**

(84) Etats contractants désignés:
**AT BE CH DE GB IT LU NL SE**

(56) Documents cités:
**AT - B - 300 368**
**FR - A - 1 230 618**
**FR - A - 2 097 510**
**FR - A - 2 340 184**
**GB - A - 986 566**

(73) Titulaire: **Société Chimique des Charbonnages Tour Aurore Place des Reflets Cédex no 5 F-92080 Paris La Défense 2 (FR)**

(72) Inventeur: **Schuller, Léon 29, l'Orée de Marly F-78590 Noisy le Roi (FR)**
Inventeur: **Meyer, Nicolas 1, Bld de la Salle des Fêtes F-62160 Bully les Mines (FR)**

(74) Mandataire: **Rieux, Michel et al, Tour Aurore Service Propriété Industrielle Place des Reflets Cédex 5 F-92080 Paris La Défense (FR)**

Courier Press, Leamington Spa, England.

Matériaux stratifiés à base de résine phénolique et procédé pour leur préparation

La présente invention concerne des matériaux stratifiés à base de résine phénolique armée d'un renfort, recouverts d'une couche de finition, et leur procédé de préparation.

Les matériaux stratifiés sont des matériaux comportant en alternance plusieurs couches successives de résine et de renfort.

Il est connu de préparer des matériaux stratifiés à base de résine phénolique (voir par exemple l'ouvrage "Encyclopedia of Polymer Science and Technology", Interscience publishers, 1970, volume 12, page 1 "Reinforced Plastics" et volume 8, page 121 "Laminates").

La résine phénolique la plus généralement utilisée est un résol. Les résols sont obtenus par polycondensation en milieu alcalin d'un aldéhyde sur un phénol. Le plus souvent les résols sont obtenus par polycondensation du formaldéhyde sur le phénol en présence de soude caustique.

Le durcissement de la résine phénolique ainsi préparée, c'est-à-dire sa réticulation en réseau tridimensionnel, est effectué à l'aide d'un catalyseur acide comme par exemple l'acide chlorhydrique, sulfurique, phosphorique, oxalique, benzènesulfonique, paratoluènesulfonique, phénolsulfonique.

Le renfort utilisé est à l'état de fibres telles que fibres cellulosiques ou de verre, de non-tissé par exemple en polyester de haut poids moléculaire, en chlorure de polyvinyle, de mat de verre ou de tissu par exemple en polyamide aromatique, en verre ou en amiante.

La préparation des matériaux stratifiés renforcés se fait par plusieurs procédés. Selon un procédé on imprègne de résine le renfort sous forme de tissu ou de non-tissé, on parfait l'imprégnation soit au rouleau, soit à la presse et on réunit plusieurs couches de renfort imprégné. On peut également préparer le matériau stratifié par enroulement d'un filament imprégné de résine. Selon un autre procédé on projette des fibres sur une couche de résine déposée sur la surface d'un moule et on poursuit le dépôt de couches de résine et de fibres autant de fois que nécessaire pour obtenir l'épaisseur désirée.

Les matériaux stratifiés en résine phénolique armée présentent de nombreux inconvénients. La surface n'est pas lisse; des micropiqûres se forment et les fibres marquent la surface en laissant apparaître leur empreinte en saillie. Si on essaie de masquer ces défauts de surface en appliquant directement sur le matériau stratifié un revêtement, par exemple une peinture à base de liant polyuréthanne, l'aspect de surface du matériau obtenu reste mauvais. On ne peut obtenir une surface lisse qu'en appliquant sur le matériau stratifié un produit bouche-pores, par exemples une résine polyuréthanne, et en ponçant la surface obtenue avant de la peindre.

On a également essayé de préparer ces stratifiés renforcés sur une couche de résine déposée sur la surface d'un moule, couche couramment appelée "gel-coat". Avec un gel-coat en résine phénolique chargée ou non, relativement mince, la surface obtenue présente des micropiqûres et l'empreinte des fibres. On peut faire disparaître les micropiqûres et l'empreinte des fibres en déposant une couche de résine phénolique plus épaisse mais on observe alors l'apparition de micro-craquelures ou faïençage.

Les phénomènes sont les mêmes si on utilise un gel-coat en résine de polyester insaturé. D'autre part, ni les résines phénoliques, ni les résines de polyester insaturé ne permettent d'obtenir une dureté superficielle suffisante.

La présente invention concerne des matériaux stratifiés à base de résine phénolique armée d'un renfort, revêtus d'une couche de finition dont la surface ne présente ni marquage par les fibres du renfort ou micropiqûres, ni faïençage même après un long temps de stockage, qui ont une dureté superficielle accrue et qui sont susceptibles de recevoir une peinture de finition sans opération de bouchage et ponçage préalable.

La présente invention a pour objet des matériaux stratifiés à base de résine phénolique armée d'un renfort, revêtus d'une couche de finition, ayant au moins 2 faces, caractérisés en ce qu'ils comportent, sur au moins une de leurs faces, une couche d'une composition à base de résine furannique, directement en contact avec la résine phénolique armée.

On a en effet constaté que la résine furannique permettait d'obtenir un revêtement lisse ayant une bonne dureté superficielle. De plus ce revêtement présente une bonne résistance chimique aux agents alcalins. Le matériau stratifié a le classement M 1 au feu suivant la norme française NF P 92501. Il est donc ininflammable.

Dans le case où l'on désire un matériau dont la surface soit d'une teinte différente de celle de la résine furannique, la couche de résine furannique est également en contact avec un revêtement d'une composition à base d'une autre résine thermodurcissable convenablement chargée et/ou pigmentée. La résine thermodurcissable peut être par exemple une résine de polyester insaturé, une résine époxyde ou une résine de polyuréthanne.

La couche de résine furannique peut également porter un simple vernis mais dans ce cas la teinte du matériau n'est pas modifiée.

La résine furannique est obtenue par polycondensation, en milieu acide, d'une composition contenant de l'alcool furfurylique. La réticulation, ou durcissement, de cette résine est réalisée de manière connue en soi, à l'aide d'un catalyseur acide. Ce catalyseur peut être un acide arènesulfonique comme l'acide benzènesulfonique, phénolsulfonique, paratoluènesulfonique, ou bien un mélange de ces acides avec des acides minéraux forts comme l'acide sulfurique ou l'acide phosphorique.

On peut ajouter à la résine furannique avant durcissement différents adjuvants: charge minérale, agent d'étalement, solvant, agent thixotrope.

La charge minérale doit être inerte aux acides. L'agent d'étalement peut être choisi parmi tous les produits connus pour donner un meilleur tendu aux revêtements, comme les huiles de silicone.

L'agent thixotrope est par exemple la silice pyrogénée, la bentonite, les fibres d'amiante chargées à la silice amorphe.

Le solvant permet de rendre la résine plus fluide si on désire la projeter à l'aide d'un pistolet. Le solvant est, par exemple, l'acétone.

La résine furannique catalysée, et éventuellement additionnée d'un ou plusieurs adjuvants, peut être appliquée sur un stratifié de résine phénolique préparé au préalable.

On applique la couche de résine furannique par la technique du gel-coat. Selon cette technique on prépare sur la ou les faces d'un moule une couche d'une composition contenant une résine furannique sur laquelle on dépose des couches alternées successives de résine phénolique et de renfort.

Un autre objet de la présente invention est dont un procédé de préparation de matériaux stratifiés à base de résine phénolique armée d'un renfort, recouverts d'une couche de finition, caractérisé en ce qu'il consiste à former sur un moule une couche d'une composition à base de résine furannique puis, après durcissement au moins partiel, à déposer sur ladite couche de résine furannique des couches successives alternées de résine phénolique et de renfort, et, après durcissement, à démouler le matériau stratifié obtenu.

Ainsi selon ce mode de préparation, la résine furannique contenant le catalyseur acide, et éventuellement un ou plusieurs adjuvants, est appliquée manuellement ou à l'aide d'un pistolet sur le moule de façon à y former une couche d'épaisseur variable, en général de 0, 1 à 2 mm. Le plus souvent l'épaisseur est de quelques dixièmes de millimètre. Sur la couche ainsi obtenue on peut comme il est connu dans les procédés de stratification sur gel-coat de résine, réaliser la stratification à l'aide de résine phénolique et de renfort, par contact à froid ou à la presse à chaud ou par injection ou par enroulement filamentaire.

La demanderesse a constaté que, contrairement aux autres résines telles que résines phénoliques ou résines de polyester insaturé, on peut effectuer la stratification sur une couche de résine furannique complètement durcie. La liaison entre le gel-coat de résine furannique et le stratifié est parfaite et il n'y a aucune trace de décollement. La stratification peut également être effectuée sur une résine furannique partiellement durcie.

Dans le cas où l'on prépare un matériau dont la surface est d'une teinte différente de celle de la couche de résine furannique, on dépose sur le moule une première couche de résine thermodurcissable convenablement chargée et/ou pigmentée mélangée à un catalyseur de durcissement et on laisse cette première couche durcir au moins partiellement. On dépose ensuite, comme décrit ci-dessus, une seconde couche de résine furannique; on laisse durcir au moins partiellement cette seconde couche, puis on forme sur cette seconde couche une stratification à l'aide d'une résine phénolique et de renfort, on laisse durcir la résine phénolique et on démoule le matériau stratifié obtenu.

La résine phénolique utilisée pour la fabrication des matériaux stratifiés de l'invention est de façon connue un résol, en particulier un résol obtenu par polycondensation de formaldéhyde et de phénol en présence de soude.

Le durcissement est obtenu par addition d'un catalyseur acide.

On emploie de préférence l'acide paratoluènesulfonique car il convient fort bien à la fois pour le durcissement de la résine phénolique armée et pour le durcissement de la résine furannique. Ainsi on utilise de préférence comme catalyseur, pour le durcissement de ces deux résines, une solution aqueuse concentrée d'acide paratoluènesulfonique.

La résine phénolique peut contenir différents adjuvants tels que charges, solvants, plastifiants. L'addition d'un plastifiant, par exemple un polyalcool comme le dipropylène glycol, permet d'obtenir des matériaux stratifiés ayant une meilleure résistance à la flexion. On peut utiliser tous les renforts connus pour les résines phénoliques. On emploie plus particulièrement les renforts à base de fibres de verre.

Les exemples non limitatifs suivants ont pour but d'illustrer l'invention.

### Exemple 1

Sur un moule traité par de la cire de Carnauba dure comme agent de démoulage, on applique au pinceau une couche de résine furannique de 0,2 mm d'épaisseur composée de: (en parties en poids)

| | |
|---|---|
| Condensat d'alcool furfurylique en milieu acide (résine QUACORR 1001—marque déposé de la firme QUAKER OATS) | 100 parties |
| Silice pyrogénée | 2 parties |
| Solution aqueuse à 65% en poids d'acide paratoluènesulfonique | 3 parties |

On laisse la couche de résine furannique durcir à température ambiante pendant 20 minutes; la surface est alors légèrement poisseuse. On dépose sur cette couche un mat de fibres de verre puis une résine phénolique obtenue par condensation du formol sur le

$$\text{phénol dans un rapport molaire} \quad \frac{\text{Formol}}{\text{Phénol}} \quad 1,5$$

ayant une viscosité de 10 poises à 20°C et un extrait sec (mesuré par chauffage de 4 g de résine en étuve à 140°C pendant 3 heures) de 75%, et contenant 10% en poids de dipropylèneglycol, et à 100 parties de laquelle on a ajouté 10 parties d'une solution aqueuse à 65% en poids d'acide paratoluènesulfonique. On fait pénétrer la résine dans le mat de fibres de verre à l'aide d'un rouleau. Le rapport pondéral $\frac{\text{verre}}{\text{résine}}$ est de $\frac{1}{3}$. On laisse durcir pendant environ 4 heures à température ambiante et on démoule le matériau composite obtenu qui présente un état de surface (côté couche de finition) reproduisant la surface du moule sans défaut.

### Exemple 2

On reprend les conditions de l'exemple 1 en laissant la résine furannique durcir complètement (surface sèche au toucher) et en commençant par appliquer une couche de résine phénolique précatalysée avant de mettre en place le mat de fibres de verre, puis en continuant comme précédemment l'addition de résine phénolique.

On obtient, après durcissement, un matériau composite en tous points semblable à celui de l'exemple 1. On n'observe aucun décollement de la couche de résine furannique.

### Exemple 3

Sur la surface d'un moule, convenablement enduite de l'agent de démoulage de l'exemple 1, monté sur une presse et chauffé à 80°C, on applique au pistolet, de façon à obtenir une couche de 0,2 mm d'épaisseur, un mélange constitué de: (en parties en poids)

| | |
|---|---|
| résine furannique de l'exemple 1 | 100 parties |
| silice pyrogénée | 2 parties |
| acétone | 10 parties |
| solution aqueuse à 65% en poids d'acide paratoluènesulfonique | 3 parties |

Le durcissement de la résine sur le moule chaud est très rapide. Au bout d'une minute la surface est sèche au toucher. On met alors en place sur cette surface le mat de fibres de verre et verse dessus la résine phénolique de l'exemple 1, dans les mêmes rapports pondéraux verre/résine. On ferme la presse. Au bout de 10 mn on démoule le matériau composite obtenu dont l'état de surface est sans défaut.

### Exemple 4

On répète l'exemple 3 en augmentant l'épaisseur de la couche de résine furannique à 1 mm. Après stockage pendant plusieurs mois de matériau composite obtenu, la surface de celui-ci ne montre aucune trace de faïençage.

### Exemple 5

Sur chacune des deux surfaces (poinçon et matrice) d'un moule destiné à être alimenté par injection, traitées par un agent de démoulage, on réalise une couche de résine furannique dans les conditions de l'exemple 2. Sur chacune de ces couches durcies complètement on met en place le tissu de verre. On ferme le moule et injecte la résine phénolique de l'exemple 1. Après une heure de durcissement à 50°C on démoule et obtient ainsi un matériau composite stratifié revêtu d'une couche de finition sur ses 2 faces.

### Exemple 6

Sur la surface d'un moule, traité par l'agent de démoulage de l'exemple 1, on applique une couche de 0,2 mm d'épaisseur d'une résine de polyester insaturé, à base d'acide isophtalique et contenant du trichloréthylphosphate et du dioxyde de titane. Sur cette couche de résine incomplètement durcie on met en place la résine furannique puis la résine phénolique et le mat de fibres de verre dans les conditions de l'exemple 2. Après durcissement et démoulage on obtient un matériau composite ayant une surface (côté gel-coat de polyester) parfaitement lisse et blanche.

**Revendications**

1. Matériaux stratifiés à base de résine phénolique armée d'un renfort revêtus d'une couche de finition, ayant au moins 2 faces, caractérisés en ce qu'ils comportent, sur au moins une de leurs faces, une couche d'une composition à base de résine furannique directement en contact avec la résine phénolique armée, la couche de résine furannique étant appliquée par la technique du gel-coat de façon à former une couche d'épaisseur comprise entre 0,1 et 2 mm, la résine furannique étant durcie à l'aide d'un catalyseur acide.

2. Matériaux selon la revendication 1, caractérisés en ce que la couche à base de résine furannique est également en contact avec un revêtement à base d'une autre résine thermodurcissable.

3. Procédé de préparation des matériaux selon la revendication 1, caractérisé en ce qu'il consiste à former sur un moule une couche d'une composition à base de résine furannique puis, après durcissement au moins partiel, à déposer sur la couche de résine furannique des couches successives alternées de résine phénolique et de renfort et, après durcissement, à démouler le matériau stratifié obtenu.

4. Procédé selon la revendication 3, caractérisé en ce que le durcissement de la résine furannique est complet.

5. Procédé de préparation des matériaux selon la revendication 2, caractérisé en ce qu'il consiste à former sur un moule une première couche d'une composition contenant une résine thermodurcissable, à laisser durcir au moins partiellement cette première couche, à former ensuite une seconde couche d'une composition à base de résine furannique, à laisser durcir au moins partiellement cette seconde couche puis à former sur cette seconde couche une stratification à l'aide d'une résine phénolique et de renfort puis à laisser durcir la résine phénolique et à démouler le matériau stratifié obtenu.

6. Procédé selon la revendication 5, caractérisé en ce que la résine thermodurcissable est une résine de polyester insaturé.

## Patentansprüche

1. Schichtmaterialien auf Basis von verstärktem Phenolharz, welche mit einer Finish-Schicht bedeckt sind und mindestens zwei Flächen aufweisen, dadurch gekennzeichnet, daß sie zumindest auf einer ihrer Flächen eine Schicht auf Basis eines Furanharzes in direktem Kontakt mit dem verstärkten Phenolharz aufweisen, wobei die Furanharzschicht durch Anwendung der Gelbeschichtungstechnik aufgetragen wurde, um eine Schicht einer Dicke zwischen 0,1 und 2,00 mm zu bilden, und das Furanharz mit Hilfe eines Säurekatalysators gehärtet wurde.

2. Materialien nach Anspruch 1, dadurch gekennzeichnet, daß die Schicht auf Basis des Furanharzes ferner mit einer Beschichtung auf Basis eines anderen wärmehärtbaren Harzes in Kontakt steht.

3. Verfahren zur Herstellung von Materialien nach Anspruch 1, dadurch gekennzeichnet, daß auf einer Gießform eine Schicht auf Basis eines Furanharzes gebildet wird, nach zumindest teilweisem Aushärten auf der Furanharzschicht nacheinander abwechselnd Phenolharzschichten und Verstärkungsschichten abgelagert werden und das so erhaltene Schichtmaterial nach dem Aushärten ausgeformt wird.

4. Verfahren nach Anspruch 3, dadurch gekennzeichnet, daß Furanharz vollständig ausgehärtet wird.

5. Verfahren zur Herstellung von Materialien nach Anspruch 2, dadurch gekennzeichnet, daß auf einer Gießform eine erste Schicht aus einer ein wärmehärtbares Harz enthaltenden Mischung gebildet wird, diese erste Schicht zumindest teilweise aushärten gelassen wird, anschließend eine zweite Schicht auf Basis von Furanharz gebildet wird, diese zweite Schicht zumindest teilweise aushärten gelassen und dann auf dieser zweiten Schicht eine Schichtanordnung aus Phenolharz und Verstärkung gebildet wird, das Phenolharz dann aushärten gelassen wird und das erhaltene Schichtmaterial ausgeformt wird.

6. Verfahren nach Anspruch 5, dadurch gekennzeichnet, daß das wärmehärtbare Harz ein ungesättigtes Polyesterharz ist.

## Claims

1. Laminated materials which have a base of phenol resin reinforced with a reinforcement and which are covered with a finishing layer, having at least 2 faces, characterised in that they comprise, on at least one of their faces, a layer of a composition having a furane resin base directly in contact with the reinforced phenol resin, the furane resin layer being applied by the gel coating technique so as to form a layer of a thickness comprised between 0.1 and 2 mm, the furane resin being hardened with the use of an acid catalyst.

2. Materials according to claim 1, characterised in that the furane resin layer is also in contact with a covering having a base of another thermosetting resin.

3. Process for the preparation of materials according to claim 1, characterised in that it consists in forming on a mould a layer of a composition having a base of furane resin then, after at least partial setting, depositing on the furane resin layer alternate successive layers of reinforcement and phenol resin and, after setting, removing from the mould the laminated material obtained.

4. Process according to claim 3, characterised in that the setting of the furane resin is complete.

5. Process for the preparation of materials according to claim 2, characterised in that it consists in forming on a mould a first layer of a composition containing a thermosetting resin, allowing this first layer to set at least partially, then forming a second layer of a composition having a furane resin base, allowing this second layer to set at least partly, then forming on this second layer a lamination with the use of a reinforcement and phenol resin, then allowing the phenol resin to set and removing from the mould the laminated material obtained.

6. Process according to claim 5, characterised in that the thermosetting resin is an unsaturated polyester resin.